# EUROPEAN PATENT APPLICATION

(11) **EP 4 836 597 A1**
(43) Date of publication of application: **04.11.2026**
(21) Application number: 24912500.6
(22) Date of filing: 17.12.2024
(51) Int. Cl.: H05K 1/09

(54) **WIRING BOARD**

(30) Priority: 26.12.2023 JP 2023219809
(71) Applicant: Kyocera Corporation, Kyoto-shi, Kyoto 612-8501 (JP)
(72) Inventor: UNOKO, Takuya, Kyoto-shi, Kyoto 612-8501 (JP); KINOSHITA, Keita, Kyoto-shi, Kyoto 612-8501 (JP)
(74) Representative: Viering, Jentschura & Partner mbB Patent- und Rechtsanwälte
(86) International application number: PCT/JP2024/044505
(87) International publication number: WO 2025/142611

(57) **Abstract**

A wiring board comprises an insulating substrate that is ceramics, and internal wiring positioned inside the insulating substrate, the internal wiring includes a sintered body of a plurality of crystal grains comprising copper as a main component, and a plurality of glass particles, in a cross section orthogonal to a longitudinal direction of the internal wiring, the internal wiring comprises a central region, an intermediate region surrounding the central region and in which the glass particles are distributed more than in the central region, and an outer peripheral region that is a region between the intermediate region and an outer periphery of the internal wiring and in which distribution of the glass particles is less than in the intermediate region, and an area density of the glass particles is lower in the outer peripheral region than in the central region and lower than in the intermediate region.

## Description

### TECHNICAL FIELD

The present disclosure relates to a wiring board.

### BACKGROUND OF INVENTION

Japanese Patent Application Laid-Open No. 2021-011411 describes a wiring board using a ceramics sintered body. The wiring board is provided with internal wiring.

### SUMMARY

### SOLUTION TO PROBLEM

A wiring board according to the present disclosure comprises:
an insulating substrate that is ceramics; and internal wiring positioned inside the insulating substrate,
the internal wiring includes a sintered body of a plurality of crystal grains comprising copper as a main component, and a plurality of glass particles,
in a cross section orthogonal to a longitudinal direction of the internal wiring, the internal wiring comprises a central region, an intermediate region surrounding the central region and in which the glass particles are distributed more than in the central region, and an outer peripheral region that is a region between the intermediate region and an outer periphery of the internal wiring and in which distribution of the glass particles is less than in the intermediate region, and
an area density of the glass particles is lower in the outer peripheral region than in the central region and lower than in the intermediate region.

### BRIEF DESCRIPTION OF THE DRAWINGS

[FIG. 1] A perspective view showing a wiring board according to an embodiment of the present disclosure.
[FIG. 2] A cross-sectional view of the wiring board including a cross section of internal wiring in FIG. 1.
[FIG. 3] A diagram explaining components of the internal wiring.
[FIG. 4] A diagram explaining a cross section of internal wiring of Embodiment 1.
[FIG. 5] A diagram explaining a cross section of internal wiring of Embodiment 2.
[FIG. 6] A diagram explaining a cross section of internal wiring of Embodiment 3.
[FIG. 7] A diagram explaining a cross section of internal wiring of Embodiment 4.
[FIG. 8] A diagram explaining a cross section of internal wiring of Embodiment 5.

### DESCRIPTION OF EMBODIMENTS

Hereinafter, embodiments of the present disclosure will be described in detail with reference to the drawings. In the present embodiment, a cross section that intersects an internal wiring 21 and is perpendicular to a longitudinal direction (that is, an extending direction) of the internal wiring 21 is simply referred to as a cross section of the internal wiring 21.

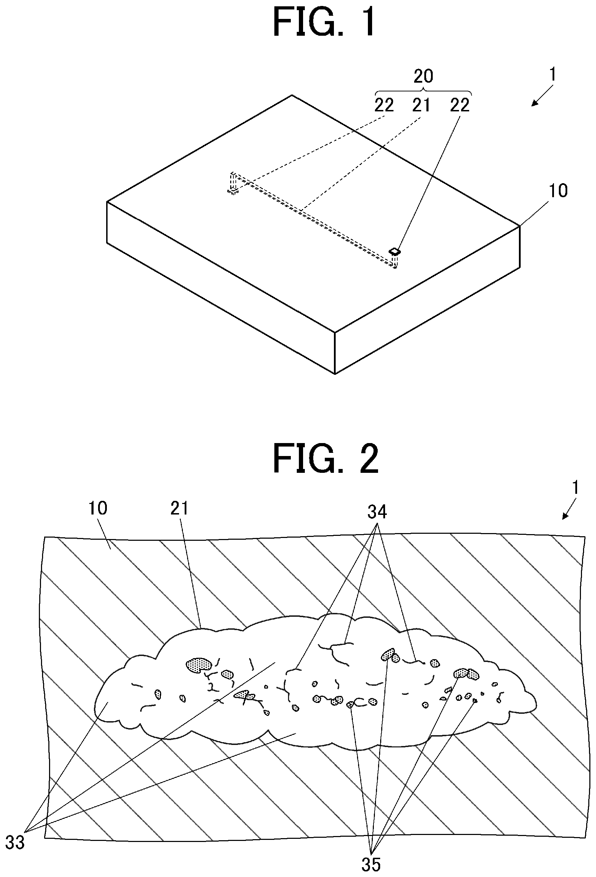

FIG. 1 is a perspective view showing a wiring board 1 according to an embodiment of the present disclosure. The wiring board 1 of the present embodiment comprises an insulating substrate 10 that is ceramics, and a wiring 20 positioned on the insulating substrate 10.

The insulating substrate 10 is a fired product having insulating properties such as ceramics. The insulating substrate 10 may be glass ceramics in which a powder material before sintering includes glass particles. The insulating substrate 10 may be configured in a plate shape. The insulating substrate may be configured such that a plurality of green sheets that are ceramic materials are laminated and fired.

The wiring 20 may include a surface wiring 22 positioned on a surface of the insulating substrate 10, and an internal wiring 21 positioned inside the insulating substrate 10. The internal wiring 21 may include a film-like conductor extending in a direction along a plate surface of the insulating substrate 10, and a via conductor extending in a direction perpendicular to the plate surface of the insulating substrate 10. Hereinafter, components of the internal wiring 21 will be described taking a film-like conductor as an example of the internal wiring 21, but components not specified as those of the film-like conductor are similarly included in the via conductor. The film-like conductor and the via conductor mainly differ in a shape of a cross section of the internal wiring 21, and the film-like conductor may have a flat shape while the via conductor may have a circular shape. The circular shape is a concept that includes not only a strict circle but also a shape in which distortion is added to a strict circle.

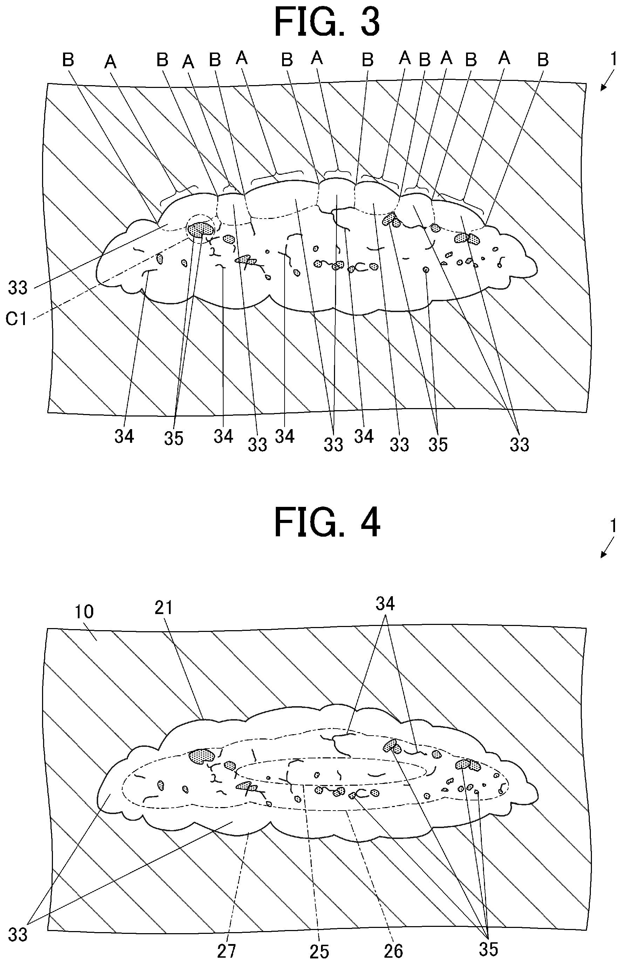

FIG. 2 is a diagram showing a cross section of the internal wiring 21. In the cross-sectional view of the internal wiring 21, hatching of crystal grains 33 constituting the internal wiring 21 is omitted. The same applies to FIGS. 3 to 8.

The internal wiring 21 may include a sintered body of a plurality of crystal grains 33 that are conductors. The sintered body of the plurality of crystal grains 33 is positioned in a portion represented in white in the internal wiring 21 in FIG. 2. The plurality of crystal grains 33 may comprise copper as a main component. The main component means occupying 70% or more in volume ratio. The crystal grains 33 may include, in addition to copper as the main component, a metal material such as silver, palladium, gold, platinum, tungsten, molybdenum, or manganese, or an alloy material or mixed material comprising these metal materials as components. The crystal grains 33 may have a volume ratio of copper of 80% or more, or 90% or more. An upper limit of the volume ratio of copper in the crystal grains 33 may be 99%.

The internal wiring 21 may further include a plurality of glass particles 35. A main component of the glass particles 35 may be silica. Including the glass particles 35 may mean that the glass particles 35 are included in a material of the internal wiring 21 before firing. With the material of the internal wiring 21, if the material of the insulating substrate 10 and the material of the internal wiring 21 are fired simultaneously, nano-sized silica accompanying the glass particles 35 moves to a boundary between the insulating substrate 10 and the internal wiring 21, and adhesion between the insulating substrate 10 and the internal wiring 21 can be enhanced. The effect of enhancing the adhesion is particularly useful in response to the insulating substrate 10 being glass ceramics that is fired at low temperature.

Next, one cross section of the internal wiring 21 will be described in detail. An appearance of the cross section can be observed in a photograph (hereinafter referred to as an SEM (Scanning Electron Microscope) photograph) taken with a scanning electron microscope after mirror-polishing the cross section. The cross section of the internal wiring 21 includes a plurality of crystal grains 33 comprising copper as a main component, a grain boundary 34 positioned at a boundary of a pair of adjacent crystal grains 33, and the glass particles 35. The grain boundary 34 is linear in the cross section. The grain boundary 34 may include silica.

The plurality of crystal grains 33 may have a case where a boundary cannot be observed in an SEM photograph by strongly adhering to an adjacent crystal grain 33 due to densification during firing. In the glass particles 35 as well, there may be a case where a boundary cannot be observed if adhering to an adjacent glass particle 35. Even in such a case, individual crystal grains 33, grain boundaries 34, and individual glass particles 35 can be distinguished as follows.

### <Example of Method for Distinguishing Individual Crystal Grains, Grain Boundaries, and Individual Glass Particles>

FIG. 3 is a diagram explaining components of the internal wiring 21. In FIG. 3, boundaries of some distinguished crystal grains 33 and boundaries of some glass particles 35 are shown. The boundaries are distinguished by the method described below and are represented by two-dot chain lines in FIG. 3. In the cross section of FIG. 3, boundaries of seven crystal grains 33 positioned at an upper center of the internal wiring 21 and boundaries of two glass particles 35 positioned at a location C1 at an upper left are shown.

Individual crystal grains 33 are configured such that what were crystal grains at a material stage before firing are densified by firing. Individual crystal grains 33 have a shape like an oblate spheroid (specifically, a spheroid of revolution) crushed from a plurality of directions by flat surfaces or curved surfaces due to densification with another adjacent crystal grain 33. On the other hand, in an outer peripheral portion of the internal wiring 21, since the crystal grains 33 are adjacent to particles of the insulating substrate 10, much roundness remains in an outer shape of the crystal grains 33. In the outer peripheral portion of the internal wiring 21, convex curved portions A that are belly portions of each of a plurality of crystal grains 33 arranged along the outer periphery, and valley portions B that are contact portions of a pair of adjacent crystal grains 33 are likely to appear. Furthermore, the grain boundaries 34 appear at boundaries of a pair of adjacent crystal grains 33, and the glass particles 35 are positioned between the plurality of crystal grains 33.

Therefore, from the convex curved portions A and valley portions B appearing in an outline of the cross section of the internal wiring 21, the grain boundaries 34 that can be observed here and there, and positions of the glass particles 35, boundaries of individual crystal grains 33, that is, sizes and outer shapes of individual crystal grains 33 can be estimated. FIG. 3 shows boundaries of seven crystal grains 33 estimated as described above at an upper center of the internal wiring 21.

The grain boundaries 34 and the glass particles 35 are displayed with a contrast different from that of the plurality of crystal grains 33 in an SEM photograph of the cross section of the internal wiring 21. Therefore, by dividing each pixel of the SEM photograph into two types by a threshold of contrast, it can be distinguished that one pixel is included in the plurality of crystal grains 33 and the other pixel is included in the grain boundaries 34 or the glass particles 35.

The grain boundaries 34 and the glass particles 35 can be distinguished by shape. The grain boundaries 34 are linear, and the glass particles 35 have a width in a two-dimensional direction that can be distinguished from the grain boundaries 34. Furthermore, individual glass particles 35 can be distinguished by an outline having roundness. As shown at a location C1 at an upper left in FIG. 3, in response to an outline including a plurality of roundnesses with continuous roundness as one roundness and having valley portions between individual roundnesses, it can be distinguished that two glass particles 35 are combined at locations of the valley portions. A boundary line estimated by the above distinction is shown between the two glass particles 35 at the location C1 in FIG. 3.

By the method as described above, individual crystal grains 33, grain boundaries 34, and individual glass particles 35 can be distinguished in the cross section of the internal wiring 21.

### (Internal Wiring of Embodiment 1)

FIG. 4 is a cross-sectional view showing internal wiring 21 according to Embodiment 1 of the present disclosure. The internal wiring 21 according to Embodiment 1 may include a central region 25, an intermediate region 26, and an outer peripheral region 27 in the cross section of the internal wiring 21. In FIG. 4, an outer periphery of the central region 25 and an outer periphery of the intermediate region 26 are shown by one-dot chain lines. The intermediate region 26 is a region that surrounds the central region 25 and in which the glass particles 35 are distributed more than in the central region 25. The outer peripheral region 27 is a region between the intermediate region 26 and an outer periphery of the internal wiring 21, and is a region in which distribution of the glass particles 35 is less than in the intermediate region 26. An area ratio occupied by the glass particles 35 may be lower in the outer peripheral region 27 than in the intermediate region 26, and may be lower in the outer peripheral region 27 than in the central region 25.

Widths in respective radial directions of the central region 25, the intermediate region 26, and the outer peripheral region 27 may be derived from distribution of the glass particles 35. That is, in response to measuring distribution of the glass particles 35 from a central portion to an outer edge portion of the internal wiring 21 in the cross section of the internal wiring 21, regions with less distribution, more distribution, and less distribution are arranged. Therefore, an intermediate region with more distribution may be set as the intermediate region 26, and an inner side and an outer side thereof may be set as the central region 25 and the outer peripheral region 27, respectively.

The outer peripheral region 27 may have zero distribution of the glass particles 35.

In response to transmitting a signal via the internal wiring 21, as a frequency band of the signal becomes higher, a skin effect appears in a current of the signal. The skin effect is a phenomenon in which a current density of a high-frequency signal is larger closer to a conductor surface and becomes smaller farther from the conductor surface. According to the internal wiring 21 of Embodiment 1, since distribution of the glass particles 35 is less in the outer peripheral region 27, resistance of a current of a high-frequency signal due to the skin effect by the glass particles 35 can be reduced, and transmission characteristics can be improved.

### <Example>

Next, results of evaluating transmission characteristics of a high-frequency signal of the wiring board 1 by actually creating the wiring board 1 will be described.

First, as a material of the insulating substrate 10, a mixture of 40 wt% of alumina particles and 60 wt% of borosilicate glass was prepared. Such a mixture is a glass ceramics raw material having a firing temperature of 900°C or more and 1000°C or less. Further, as an organic binder, 20 parts by mass of isobutyl methacrylate resin and dibutyl phthalate were used with respect to 100 parts by mass of the glass ceramics raw material, and a plurality of green sheets having dimensions of 90 mm × 80 mm and thicknesses of 50 µm and 75 µm were produced by doctor blade molding.

Further, as a raw material of the internal wiring 21, copper powder having a particle size of 1 µm to 5 µm and an average particle size of 2 µm, and silica particles having a particle size of 20 nm to 50 nm and an average particle size of 30 nm were prepared. An addition amount of the silica particles was 1 part by mass with respect to 100 parts by mass of the copper powder. Further, as an organic binder, isobutyl methacrylate resin and a mixed solvent of butyl carbitol acetate and dibutyl phthalate were used. Isobutyl methacrylate resin was added at a ratio of 5 parts by mass with respect to 100 parts by mass of the copper powder, and further a mixed solvent of butyl carbitol acetate and dibutyl phthalate was added to prepare a conductor paste containing the copper powder and the silica particles.

The conductor paste described above was printed in a predetermined arrangement on both surfaces of the produced green sheet, and through holes were formed between both surfaces at predetermined positions of the green sheet, and the through holes were filled with the conductor paste. The conductor paste printed on the surface of the green sheet is a configuration before firing of a film-like conductor of the internal wiring 21, and the conductor paste filled in the through holes is a configuration before firing of a via conductor of the internal wiring 21. Furthermore, a plurality of green sheets including the conductor paste were stacked to produce a material before firing. A thickness of the material before firing was 2 mm.

The produced material before firing was fired in a reducing atmosphere using a mixed gas of hydrogen and nitrogen at a maximum temperature of 930°C and a holding time of 2 hours.

If observing SEM photographs of cross sections of the internal wiring 21 at a plurality of locations of the wiring board 1 fired as described above, it was confirmed that there was a difference among the central region 25, the intermediate region 26, and the outer peripheral region 27 described above regarding distribution of the glass particles 35. Furthermore, it was confirmed that the glass particles 35 were not positioned in the outer peripheral region 27.

Frequency characteristics of wiring included in the produced wiring board 1 were measured and compared with a wiring board in which glass particles were included in an outer peripheral region and other configurations were substantially the same. As a result, it was confirmed that insertion loss of a high-frequency signal was improved by about 0.1 dB in a band of 8 GHz to 15 GHz, and was improved by 0.1 to 0.25 dB in a band of 20 GHz to 70 GHz.

The manufacturing method described above is merely an example of a method for manufacturing the wiring board 1 of the present embodiment, and manufacturing parameters capable of manufacturing the wiring board 1 of the present embodiment can be selected from a relatively wide range. Manufacturing parameters in which distribution of the glass particles 35 included in the internal wiring 21 is large in the intermediate region 26 and is almost zero in the outer peripheral region 27 can be easily found by trials of not so many times.

### (Embodiment 2)

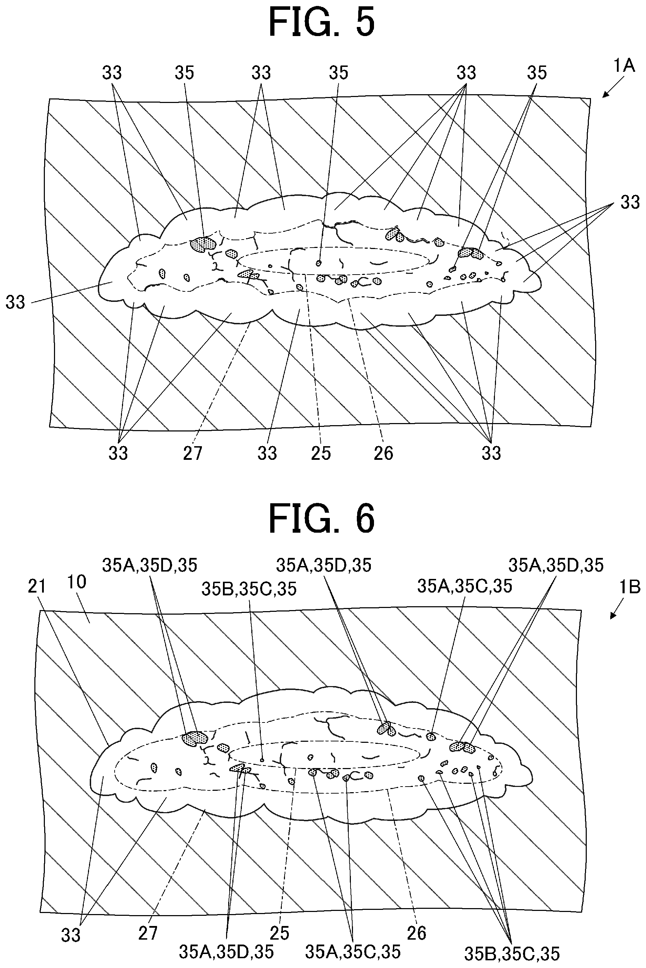

FIG. 5 shows a cross-sectional view of a wiring board 1A according to Embodiment 2 of the present disclosure. Embodiment 2 differs in that the outer peripheral region 27 is specified by the crystal grains 33, and other components may be the same as in Embodiment 1.

As shown in FIG. 5, the outer peripheral region 27 may be a region in which a plurality of crystal grains 33 in contact with an outer periphery of the internal wiring 21 are continuous in a circumferential direction. The crystal grains 33 may have a particle size of 1 µm to 5 µm. The particle size means an average value of a major axis and a minor axis. The particle size can be realized by adjusting a particle size of crystal grains at a material stage. Distribution of the glass particles 35 in the outer peripheral region 27 may be zero.

The configuration means that a ratio at which the glass particles 35 are interposed at a boundary with another crystal grain 33 adjacent in a circumferential direction is low or zero for each of a plurality of crystal grains 33 positioned at an outermost periphery of the internal wiring 21. Furthermore, a width in a radial direction of the outer peripheral region 27 corresponds to a particle size of the crystal grains 33.

According to the wiring board 1A of Embodiment 2, by increasing denseness between a plurality of crystal grains 33 positioned at an outermost periphery of the internal wiring 21, the area ratio of the outer peripheral region 27 occupied by the glass particles 35 can be easily made low or zero. Furthermore, a width in a radial direction of the outer peripheral region 27 in which an area ratio occupied by the glass particles 35 is low or zero can be controlled at a material selection stage by a particle size of the crystal grains 33. Then, by the outer peripheral region 27, an effect is achieved that resistance of a current of a high-frequency signal due to the skin effect by the glass particles 35 is reduced, and transmission characteristics in a high frequency band are improved.

Furthermore, since a particle size of the crystal grains 33 is 1 µm to 5 µm, the outer peripheral region 27 in which an area ratio occupied by the glass particles 35 is low or zero is formed in a range of a width of 1 µm to 5 µm along an outer periphery of the internal wiring 21. Therefore, transmission characteristics can be improved from a frequency band of about 8 GHz in which a width of a surface layer where current density becomes high due to the skin effect is 1 µm to 5 µm.

The wiring board 1A having the configuration of Embodiment 2 can be manufactured by the manufacturing method shown in the example of Embodiment 1.

### (Embodiment 3)

FIG. 6 shows a cross-sectional view of a wiring board 1B according to Embodiment 3 of the present disclosure. Embodiment 3 differs in that a distribution mode of the glass particles 35 included in the internal wiring 21 is specified, and other components may be the same as in any of Embodiments 1 and 2.

As shown in FIG. 6, in the cross section of the internal wiring 21, the plurality of glass particles 35 may include first glass particles 35A having a particle size of 2 µm to 4 µm, and second glass particles 35B having a particle size of less than 2 µm. The configuration can be realized by adjusting a particle size of glass particles at a material stage. The first glass particles 35A may be called large glass particles. The second glass particles 35B may be called small glass particles.

Furthermore, in the cross section of the internal wiring 21, the second glass particles 35B may be scattered around the first glass particles 35A. Furthermore, the plurality of glass particles 35 may include independent particles 35C positioned independently. Furthermore, the plurality of glass particles 35 may include composite particles 35D continuous so as not to form a ring. According to the distribution mode of the glass particles 35, since the glass particles 35 are dispersed in the central region 25 and the intermediate region 26, gathering at one location to become large, being continuous so as to form a ring, or being continuous in a lattice shape can be reduced or made zero.

Furthermore, in the cross section of the internal wiring 21, the first glass particles 35A may be distributed more in the intermediate region 26 than in the central region 25.

According to the distribution of the first glass particles 35A, since the first glass particles 35A are distributed more in the intermediate region 26 that is wider than the central region 25, the first glass particles 35A can be easily dispersed. Therefore, the glass particles 35 gathering at one location to become large can be reduced.

The glass particles 35 largely gathered at one location increase conductor loss in the internal wiring 21, and the glass particles 35 continuous so as to form a ring or in a lattice shape further increase conductor loss in the internal wiring 21. Therefore, according to the wiring board 1B of Embodiment 3, the internal wiring 21 with low conductor loss can be provided.

The wiring board 1B having the configuration of Embodiment 3 can be manufactured by the manufacturing method shown in the example of Embodiment 1.

### (Embodiment 4)

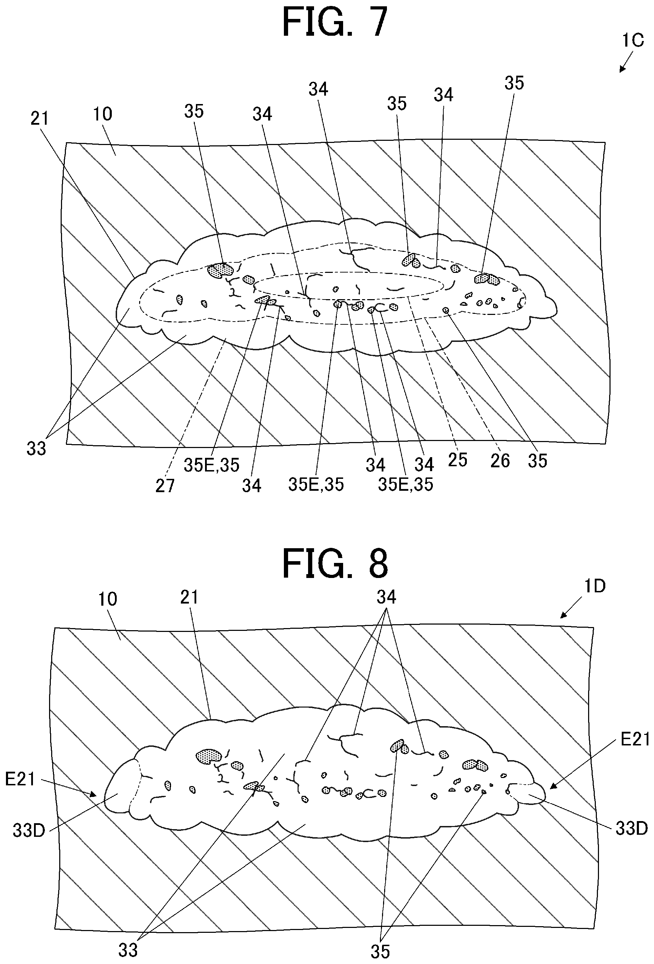

FIG. 7 shows a cross-sectional view of a wiring board 1C according to Embodiment 4 of the present disclosure. Embodiment 4 differs in that a distribution mode of grain boundaries 34 included in the internal wiring 21 is specified, and other components may be the same as in any of Embodiments 1 to 3.

As shown in FIG. 7, in the cross section of the internal wiring 21, a total length of the grain boundaries 34 may be longer in the intermediate region 26 than in the outer peripheral region 27. Distribution of the grain boundaries 34 in the outer peripheral region 27 may be zero. Furthermore, in the cross section of the internal wiring 21, the plurality of glass particles 35 may include connected particles 35E connected to the grain boundaries 34, and the outer peripheral region 27 may not include the connected particles 35E.

The grain boundaries 34 are configured to spread in a planar shape in a three-dimensional space, and may extend obliquely along a longitudinal direction of the internal wiring 21. Furthermore, the grain boundaries 34 become a factor of current resistance. Therefore, in response to the grain boundaries 34 being many in the outer peripheral region 27, conductor loss of a portion where current density becomes high due to the skin effect is increased. Further, the connected particles 35E generate resistance with a wide width in the internal wiring 21. Therefore, in response to the connected particles 35E being in the outer peripheral region 27, conductor loss of a portion where current density becomes high due to the skin effect is increased. On the other hand, according to the distribution mode of the grain boundaries 34 and the distribution mode of the connected particles 35E of the wiring board 1C of Embodiment 4, conductor loss of a portion where current density becomes high due to the skin effect of the internal wiring 21 can be reduced. Therefore, transmission characteristics of a signal at a high frequency of the wiring board 1C can be further improved.

The wiring board 1C having the configuration of Embodiment 4 can be manufactured by the manufacturing method shown in the example of Embodiment 1.

### (Embodiment 5)

FIG. 8 shows a cross-sectional view of a wiring board 1D according to Embodiment 5 of the present disclosure. Embodiment 5 differs in that a part of a cross-sectional outer shape of the internal wiring 21 as a film-like conductor is specified, and other components may be the same as in any of Embodiments 1 to 4.

The internal wiring 21 that is a film-like conductor has a shape in which a horizontal dimension is longer than a vertical dimension in the cross section of the internal wiring 21, and a contour of an end portion E21 in a horizontal direction may be in a convex curved shape. That is, it may be an end portion having roundness without having a sharp corner. Specifically, one end portion in the horizontal direction may be occupied by one crystal grain 33D.

According to the configuration, in response to a signal being transmitted via the internal wiring 21 that is a film-like conductor, concentration of an electric field generated due to the signal at an end portion in a horizontal direction can be reduced. Therefore, reduction of conductor loss of the internal wiring 21 can be achieved.

The wiring board 1D having the configuration of Embodiment 5 can be manufactured by the manufacturing method shown in the example of Embodiment 1.

Each embodiment of the present disclosure has been described above. However, the wiring board of the present disclosure is not limited to the above embodiments, and details shown in the embodiments can be appropriately changed within a range not departing from a gist of the invention.

Hereinafter, one embodiment of the present disclosure is shown. In one embodiment,
(1) A wiring board comprises:
   an insulating substrate that is ceramics; and internal wiring positioned inside the insulating substrate,
   the internal wiring includes a sintered body of a plurality of crystal grains comprising copper as a main component, and a plurality of glass particles,
   in a cross section orthogonal to a longitudinal direction of the internal wiring, the internal wiring comprises a central region, an intermediate region surrounding the central region and in which the glass particles are distributed more than in the central region, and an outer peripheral region that is a region between the intermediate region and an outer periphery of the internal wiring and in which distribution of the glass particles is less than in the intermediate region, and
   an area density of the glass particles is lower in the outer peripheral region than in the central region and lower than in the intermediate region.
(2) In the wiring board of (1) above,
   the glass particles are not distributed in the outer peripheral region.
(3) In the wiring board of (1) or (2) above,
   in a cross section orthogonal to a longitudinal direction of the internal wiring, the outer peripheral region is a region in which a plurality of the crystal grains in contact with an outer periphery of the internal wiring are continuous in a circumferential direction.
(4) In the wiring board of any one of (1) to (3) above,
   the crystal grains have a particle size of 1 µm to 5 µm.
(5) In the wiring board of any one of (1) to (4) above,
   the plurality of glass particles include first glass particles having a particle size of 2 µm to 4 µm, and second glass particles having a particle size of less than 2 µm.
(6) In the wiring board of (5) above,
   the second glass particles are scattered around the first glass particles.
(7) In the wiring board of (5) or (6) above,
   the first glass particles are distributed more in the intermediate region than in the central region.
(8) In the wiring board of any one of (1) to (7) above,
   the plurality of glass particles include independent particles positioned independently.
(9) In the wiring board of any one of (1) to (8) above,
   the plurality of glass particles include composite particles in which two or more of the glass particles are continuous so as not to form a ring.
(10) In the wiring board of any one of (1) to (9) above,
   the internal wiring includes a grain boundary positioned between the plurality of crystal grains and including silica, and
   in a cross section orthogonal to a longitudinal direction of the internal wiring, a total length of the grain boundary is longer in the intermediate region than in the outer peripheral region.
(11) In the wiring board of (10) above,
   the outer peripheral region does not include the grain boundary.
(12) In the wiring board of (10) or (11) above,
   the plurality of glass particles include connected particles connected to the grain boundary, and
   the outer peripheral region does not include the connected particles.
(13) In the wiring board of any one of (1) to (12) above,
   in a cross section orthogonal to a longitudinal direction of the internal wiring, the internal wiring has a shape in which a horizontal dimension is longer than a vertical dimension, and a contour of an end portion in a horizontal direction is in a convex curved shape.
(14) In the wiring board of (13) above,
   one end portion in the horizontal direction is occupied by one of the crystal grains.

### INDUSTRIAL APPLICABILITY

The present disclosure can be utilized for wiring boards.

### REFERENCE SIGNS

1, 1A to 1D wiring board
10 insulating substrate
20 wiring
21 internal wiring
25 central region
26 intermediate region
27 outer peripheral region
33, 33D crystal grain
34 grain boundary
35 glass particle
35A first glass particle
35B second glass particle
35C independent particle
35D composite particle
35E connected particle
E21 end portion

## Claims

1. A wiring board comprising:
an insulating substrate that is ceramics, and
internal wiring positioned inside the insulating substrate,
wherein the internal wiring includes a sintered body of a plurality of crystal grains comprising copper as a main component, and a plurality of glass particles,
wherein in a cross section orthogonal to a longitudinal direction of the internal wiring, the internal wiring comprises a central region, an intermediate region surrounding the central region and in which the glass particles are distributed more than in the central region, and an outer peripheral region that is a region between the intermediate region and an outer periphery of the internal wiring and in which distribution of the glass particles is less than in the intermediate region, and
wherein an area density of the glass particles is lower in the outer peripheral region than in the central region and lower than in the intermediate region.

2. The wiring board according to Claim 1, wherein
the glass particles are not distributed in the outer peripheral region.

3. The wiring board according to Claim 1 or Claim 2, wherein
in a cross section orthogonal to a longitudinal direction of the internal wiring, the outer peripheral region is a region in which a plurality of the crystal grains in contact with an outer periphery of the internal wiring are continuous in a circumferential direction.

4. The wiring board according to any one of Claim 1 to Claim 3, wherein
the crystal grains have a particle size of 1 µm to 5 µm.

5. The wiring board according to any one of Claim 1 to Claim 4, wherein
the plurality of glass particles include first glass particles having a particle size of 2 µm to 4 µm, and second glass particles having a particle size of less than 2 µm.

6. The wiring board according to Claim 5, wherein
the second glass particles are scattered around the first glass particles.

7. The wiring board according to Claim 5 or Claim 6, wherein
the first glass particles are distributed more in the intermediate region than in the central region.

8. The wiring board according to any one of Claim 1 to Claim 7, wherein
the plurality of glass particles include independent particles positioned independently.

9. The wiring board according to any one of Claim 1 to Claim 8, wherein
the plurality of glass particles include composite particles in which two or more of the glass particles are continuous so as not to form a ring.

10. The wiring board according to any one of Claim 1 to Claim 9, wherein
the internal wiring includes a grain boundary positioned between the plurality of crystal grains and including silica, and
in a cross section orthogonal to a longitudinal direction of the internal wiring, a total length of the grain boundary is longer in the intermediate region than in the outer peripheral region.

11. The wiring board according to Claim 10, wherein
the outer peripheral region does not include the grain boundary.

12. The wiring board according to Claim 10 or Claim 11, wherein
the plurality of glass particles include connected particles connected to the grain boundary, and
the outer peripheral region does not include the connected particles.

13. The wiring board according to any one of Claim 1 to Claim 12, wherein
in a cross section orthogonal to a longitudinal direction of the internal wiring, the internal wiring has a shape in which a horizontal dimension is longer than a vertical dimension, and a contour of an end portion in a horizontal direction is in a convex curved shape.

14. The wiring board according to Claim 13, wherein
one end portion in the horizontal direction is occupied by one of the crystal grains.
